# EUROPEAN PATENT APPLICATION

(11) **EP 4 220 301 A1**
(43) Date of publication of application: **02.08.2023**
(21) Application number: 21872743.6
(22) Date of filing: 26.08.2021
(51) Int. Cl.: G03F 7/038, G03F 7/004

(54) **I-LINE NEGATIVE PHOTORESIST COMPOSITION FOR REDUCING HEIGHT DIFFERENCE BETWEEN CENTER AND EDGE AND REDUCING LER, AND I-LINE NEGATIVE PHOTORESIST COMPOSITION FOR IMPROVING PROCESS MARGIN**

(30) Priority: 24.09.2020 KR 20200123788
(71) Applicant: Young Chang Chemical Co., Ltd., Seongju-gun, Gyeongsangbuk-do 40046 (KR)
(72) Inventor: LEE, Su Jin, Daegu 42634 (KR); CHOI, Young Cheol, Gumi-si, Gyeongsangbuk-do 39179 (KR); LEE, Seung Hyun, Daegu 42747 (KR); LEE, Seung Hun, Dalseong-gun Daegu 42918 (KR)
(74) Representative: Ter Meer Steinmeister & Partner
(86) International application number: PCT/KR2021/011426
(87) International publication number: WO 2022/065713

(57) **Abstract**

The present invention is for providing an I-line negative photoresist composition exhibiting better process margin than a conventional I-line negative photoresist, has the purpose of alleviating a problem in which the center of a contact hole pattern is dented during pattern formation, and relates to an I-line negative photoresist composition for reducing the height difference, between the center and the edge, formed by the denting of the center and for reducing line edge roughness (LER) during pattern formation in a semiconductor process, the composition comprising: a polymer resin; a compound represented by chemical formula 1; a crosslinking agent; a photoacid generator; an acid diffusion inhibitor; and a solvent.

## Description

### Technical Field

The present invention relates to an I-line negative photoresist composition with a good process margin and more particularly to an I-line negative photoresist composition for reducing a center-edge high difference and a line and edge roughness (LER) value of process margins.

### Background Art

Recently, with the advancement of semiconductor device manufacturing process technology, there is an increasingly strong demand for miniaturization and high integration of semiconductor devices. To meet this demand, a technology for realizing an ultra-fine pattern having a line width of several tens of nm or less is required. Technological advances to form such ultra-fine patterns have been made by light sources having smaller wavelengths, development of process technology according to light sources, and development of photoresists suitable for light sources.

A photoresist is used in a photolithography process for forming various patterns. A photoresist refers to a photosensitive resin having variable solubility in a developing solution, which changes by the action of light. Due to this characteristic, the photoresist provides an image corresponding to an exposure pattern.

The photoresist pattern forming methods includes negative tone development (NTD) and positive tone development (PTD).

A pattern forming method using the negative tone development refers to a method of obtaining a pattern by selectively dissolving and removing a non-exposed region with a negative tone development developer, and a pattern forming method using the positive tone development refers to a method of obtaining a pattern by dissolving and removing an exposed region with a positive tone developer.

As compared with the pattern forming method using the positive tone development, the pattern forming method using the negative tone development is relatively easy to form a contact hole or trench pattern which suffers insufficient light exposure by implementing a reverse phase pattern. In addition, the pattern forming method using the negative tone development can more effectively form a photoresist pattern by using an organic solvent as a developer. In addition, in the case of forming a contact hole pattern using a negative photoresist for the fabrication of CIS devices or the like, there is the problem that the process margin is insufficient due to a phenomenon in which a middle portion of a pattern is depressed, and the problem affects the product yield.

On the other hand, a photolithography process using a photoresist composition includes a step of applying a photoresist on a wafer, a soft baking step of heating the applied photoresist to evaporate a solvent, an imaging step of imaging on the photoresist using a light source and a photomask selectively allowing transmission of light emitted from the light source, a step of forming a photoresist pattern using a solubility difference in a developer between an exposed region and an unexposed region of the photoresist, and a step of selectively etching an underling layer using the photoresist pattern as a mask, thereby forming a circuit.

The photoresist composition is composed of a photosensitizer (also called photo acid generator) that generates photo acid when irradiated with an excimer laser beam, a base resin, and other additives. The base resin has a phenol structure provided with a hydroxyl group, and polystyrene polymers, Cresol polymers, and Novolac polymers are used as the base resin. As the photosensitizer, all materials that can generate acids (H⁺) at specific wavelengths can be used. Organic acids such as sulfonium salts, sulfonyl diazo compounds, benzylsulfonyl compounds, iodines, chlorines, and carboxylic acids, and inorganic acids are mainly used.

However, since negative photoresists prepared by using the above-described composition have the disadvantage that the photosensitizer cannot generate a sufficient amount of acids (H⁺), there is a problem in that it is difficult to form the desired shape with the use of a negative photoresist, and a worse profile is made in the case of a process of forming a finer pattern.

In such processes, an I-line laser, a KrF excimer laser, or an ArF excimer laser is used a light source. These light sources exhibit light with a wavelength range of 365 nm to 193 nm. It is known that the shorter the wavelength, the finer the pattern can be formed. Regarding negative photoresists for an I-line light source among the light sources, there are some related arts. Specifically, as patent documents, Korean Patent Application Publication No. 2013-0032071 discloses "I-line Photoresist Composition and Fine-pattern Forming Method Using Same" and Korean Patent No. 10-1598826 discloses "I-line Negative Photoresist Composition Having Excellent Etch Resistance".

### [Document of Related Art]

### [Patent Document]

(Patent Document 1) Korean Patent Application Publication No. 2013-0032071
(Patent Document 2) Korean Patent No. 10-1598826

### Disclosure

### Technical Problem

An objective of the present invention is to provide an I-line negative photoresist composition with a better process margin than conventional I-line negative photoresists, and specifically an I-line negative photoresist composition for reducing a center-edge high difference and a line and edge roughness (LER) value among process margins.

### Technical Solution

To accomplish the above objective, the present invention provides an I-line negative photoresist composition characterized by including a compound represented by Formula 1.

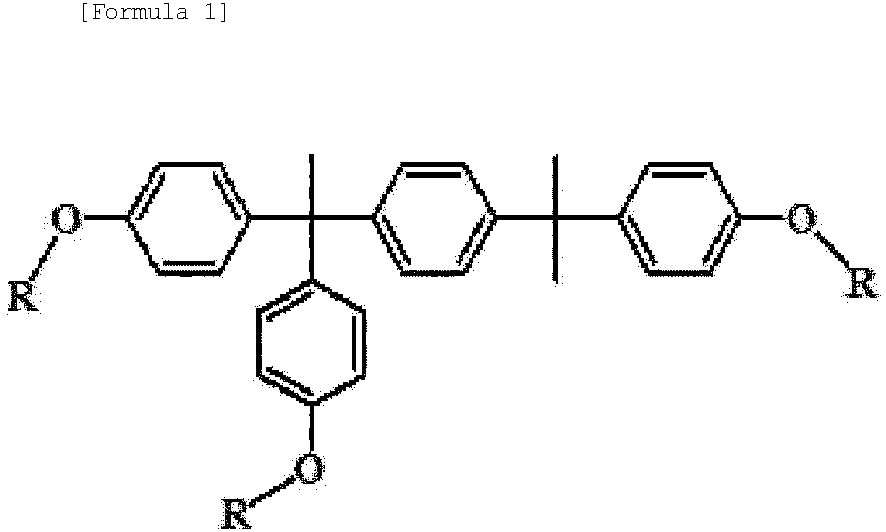

In the formula, R may be the same or different from each other and may be each independently any one selected from the group consisting of acryloyl, allyl, 3-etoxyacryloyl, dimethylsilaneallyl, methylacryl, trans-3-(benzoyl)acryl, 3-(2furyl)acryl, 4-(benzyloxy)benzyl, and 1,4-bisacryloylpiperazine.

In one preferred embodiment of the present invention, the compound represented by Formula 1 is a compound obtained by a monomer substitution reaction of 1,1,1-tris(4-hydroxyphenyl)-1-ethyl-4-isopropylbenzene.

In one preferred embodiment of the present invention, the compounds represented by Formula 1 may have each a weight average molecular weight in a range of 550 to 600.

In one preferred embodiment of the present invention, the composition includes a polymer resin, a compound represented by Formula 1, a crosslinking agent, a photoacid generator, an acid diffusion inhibitor, and a solvent. Specifically, per 100 parts by weight of the polymer resin, the composition includes 5 to 100 parts by weight of the compound represented by Formula 1, 7 to 13 parts by weight of the crosslinking agent, 1 to 7 parts by weight of the photo acid generator, 0.3 to 0.9 parts by weight of the acid diffusion inhibitor, and 700 to 1000 parts by weight of the solvent.

In one preferred embodiment of the present invention, the polymer resin may be at least one selected from the group consisting of a phenolic polymer resin containing a hydroxyl group and having a weight average molecular weight of 2,000 to 25,000, and a cresol polymer having a weight average molecular weight of 2,000 to 25,000.

In one preferred embodiment of the present invention, the phenolic polymer resin may be formed from one or more monomers selected from the group consisting of 4-hydroxy-3-methyl benzoic acid, 4-hydroxy-2-methyl benzoic acid, 5-hydroxy-2-methyl benzoic acid, 3,5-di-tert-butyl-4-hydroxy benzoic acid, 4-hydroxy-3,5-dimethyl benzoic acid, 4-hydroxy isophthalic acid, 2,4,6-hydroxy toluene, 2,4,6-trihydroxy benzoic acid monohydrate, and 2,4,6-trihydroxy benzaldehyde, and the cresol polymer resin may be formed from one or more monomers selected from the group consisting of ortho-cresol (o-cresol), para-cresol (p-cresol), meta-cresol (m-cresol), epoxy o-cresol, epoxy p-cresol, and epoxy m-cresol.

In one preferred embodiment of the present invention, the crosslinking agent may be one or more selected from the group consisting of tris(2,3-epoxypropyl)isocyanurate, trimethylolmethanetriglycidylether, trimethylolpropanetriglycidylether, hexamethylolmelamine, trimethylolethanetriglycidylether, hexamethoxymethylmelamine, hexamethoxyethylmelamine, tetramethylol 2,4-diamino-1,3,5-triazine, tetramethoxymethyl-2,4-diamino-1,3, 5-triazine, tetramethylolglycoluril, tetramethoxymethylglycoluril, tetramethoxyethylglycoluril, tetramethylolurea, tetramethoxymethylurea, tetramethoxyethylurea, and tetramethoxyethyl-2,4-diamino-1,3,5-troazine.

In one preferred embodiment of the present invention, the photoacid generator may be one or more selected from the group consisting of tris(trichloromethyl)triazine, 1,1-bis(p-chlorophenyl)-2,2,2,-trichloroethane, tris(methanesulfonyl)benzene, 1,1-bis(chlorophenyl)-2,2,2,-trichloroethanol, 2,4,6-tris(tribromomethyl)-s-triazine, 2-methyl-4,6-bis(tribromomethyl)-s-triazine, 2-phenyl-4,6-bis(tribromomethyl)-s-triazine, 2-(4-methoxy-phenyl)-4,6-bis(trichloromethyl)-1,3,5-triazine, 2,4,6,-tris(chloromethyl)1,3,5-triazine, triphenylsulfoniumtriflate, and tribromopheylsulfone.

In one preferred embodiment of the present invention, the acid diffusion inhibitor may be one or more selected from the group consisting of methyltriamine, ethyltriamine, dimethylamine, diethylamine, trimethylamine, triethylamine, tributhylamine, methanoltriamine, ethanoltriamine, dimethanolamine, diethanolamine, trimethanolamine, triethanolamine, and tributanolamine.

### Advantageous Effects

The present invention is an I-line negative photoresist composition exhibits a better process margin than conventional I-line negative photoresists and exhibits an effect of reducing a center-edge high difference and a line and edge roughness (LER) value among process margins.

### Best Mode

Unless otherwise defined, all terms including technical and scientific terms used herein have the same meaning as commonly understood by those who are ordinarily skilled in the art to which this invention belongs. In general, the nomenclature used herein is well-known and commonly used in the art.

It will be further understood that the terms "comprises", "includes", or "has", when used in this specification, specify the presence of an element, but do not preclude the presence or addition of one or more other elements unless the context clearly indicates otherwise.

In the present invention, the term "photoresist" refers to a mixture of a polymer and a photosensitizer. The photoresist changes in chemical properties thereof when irradiated with light, so that the solubility of the photoresist with respect to a particular solvent changes. That is, an exposed region and an unexposed region of the photoresist differ in dissolution rate. When a predetermined time has elapsed, a region that is not dissolved and remains becomes a pattern.

In the present invention, the term "photolithographic process" refers to a process in which when a mask in which a circuit of a semiconductor device is engraved is disposed between a light source and a wafer on which a photoresist layer is formed, and the light source is turned on, the circuit engraved in the mask is transferred to the photoresist as it is due to the properties of the photoresist.

In the present invention, the term "ray" means a light source having a wavelength band around 365 nm.

One embodiment of the present invention provides an I-line negative photoresist composition including a compound represented by Formula 1 below.

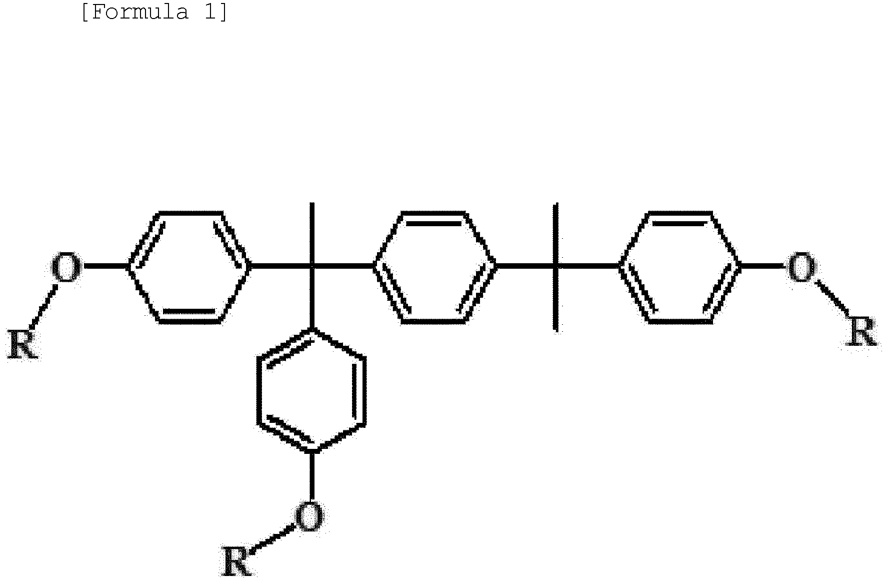

In the formula, R may be the same or different from each other and may be each independently any one selected from the group consisting of acryloyl, allyl, 3-etoxyacryloyl, dimethylsilaneallyl, methylacryl, trans-3-(benzoyl)acryl, 3-(2furyl)acryl, 4-(benzyloxy)benzyl, and 1,4-bisacryloylpiperazine.

The compound represented by Formula 1 is a compound obtained by a monomer substitution reaction of 1,1,1-tris(4-hydroxyphenyl)-1-ethyl-4-isopropylbenzene.

Reaction Formula 1 below shows an example of a substitution reaction between a monomer and a structure having 1,1,1-tris (4-hydroxyphenyl) -1-ethyl-4-isopropylbenzene.

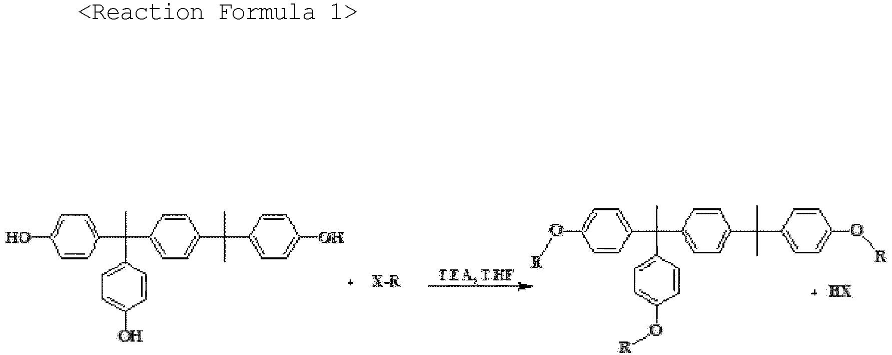

In Reaction Formula 1, X-R represents a reactive monomer, in which X is one or more selected from the group consisting of Cl, NH₂, Br, OH, and OCH₃, and R is one or more selected from the group consisting of acryloyl, allyl, 3-ethoxyacryloyl, dimethylsilaneallyl, methylacryl, trans-3-(benzoyl)acryl, 3-(2furyl)acryl, 4-(benzyloxy)benzyl, and 1,4-bisacrylopiperazine.

Specific examples of the reactive monomer include acryloylchloride, arylchlorid, acryloylbromide, arylchloriddimethylsilrane, acrylicacid, bromoacetonephenone, anthraquinonecarbonyl chloride, arylbromidedimethylsilrane, chloroacetonephenone, chloroanthracene, and bromoanthracene.

As described above, the compound represented by Formula 1 obtained by the substitution reaction may have a weight average molecular weight of 550 to 600.

The I-line negative photoresist composition according to the present invention includes a polymer resin, a compound represented by Formula 1, a crosslinking agent, a photoacid generator, an acid diffusion inhibitor, and a solvent. Specifically, the composition includes the composition includes 5 to 100 parts by weight of the compound represented by Formula 1, 7 to 13 parts by weight of the crosslinking agent, 1 to 7 parts by weight of the photo acid generator, 0.3 to 0.9 parts by weight of the acid diffusion inhibitor, and 700 to 1000 parts by weight of the solvent, per 100 parts by weight of the polymer resin.

Preferably, the compound represented by Formula 1 includes 5 to 100 parts by weight based on 100 parts by weight of the polymer resin. When the compound is used in an amount of less than 5 parts by weight, the effect of reducing a pattern center-edge high difference (i.e., a phenomenon in which a middle portion of a pattern is depressed) is insignificant and thus the effect improving performance such as a profile is also insignificant. On the other hand, when the compound is used in an amount of greater than 100 parts by weight, the pattern center-edge height difference can be reduced, such an overdose results in defects in terms of line and edge roughness and insufficient resolution.

The polymer resin may be one or more resins selected from the group consisting of a phenolic polymer resin containing a hydroxyl group and a cresol polymer resin.

More specifically, the phenolic polymer resin may be formed from one or more monomers selected from the group consisting of 4-hydroxy-3-methyl benzoic acid, 4-hydroxy-2-methyl benzoic acid, 5-hydroxy-2-methyl benzoic acid, 3,5-di-tert-butyl-4-hydroxy benzoic acid, 4-hydroxy-3,5-dimethyl benzoic acid, 4-hydroxy isophthalic acid, 2,4,6-hydroxy toluene, 2,4,6-trihydroxy benzoic acid monohydrate, and 2,4,6-trihydroxy benzaldehyde The cresol polymer resin may be formed from one or more monomers selected from the group consisting of ortho-cresol (o-cresol), para-cresol (p-cresol), meta-cresol (m-cresol), epoxy o-cresol, epoxy p-cresol, and epoxy m-cresol.

Preferably, the polymer resin is a base material of the photoresist composition, and is preferably included in an amount of 100 parts by weight in the composition of the present invention. When the polymer resin is used in an amount of less than a reference level, 100 parts by weight, there is a problem that high exposure energy is required for patterning and development. When the polymer resin is used in an amount exceeding the reference level, 100 parts by weight, it is difficult to form a uniform pattern. Therefore, there is a problem that residual matter occurs.

The crosslinking agent may include at least one selected from the group consisting of: In one preferred embodiment of the present invention, the crosslinking agent may be one or more selected from the group consisting of tris(2,3-epoxypropyl)isocyanurate, trimethylolmethanetriglycidylether, trimethylolpropanetriglycidylether, hexamethylolmelamine, trimethylolethanetriglycidylether, hexamethoxymethylmelamine, hexamethoxyethylmelamine, tetramethylol 2,4-diamino-1,3,5-triazine, tetramethoxymethyl-2,4-diamino-1,3, 5-triazine, tetramethylolglycoluril, tetramethoxymethylglycoluril, tetramethoxyethylglycoluril, tetramethylolurea, tetramethoxymethylurea, tetramethoxyethylurea, and tetramethoxyethyl-2,4-diamino-1,3,5-troazine.

Preferably, the crosslinking agent will be included in an amount of 7 to 100 parts by weight based on 100 parts by weight of the polymer resin. When the content of the crosslinking agent is less than 7 parts by weight, it may be impossible to form a pattern due to an excessively low remaining film rate. When the content of the crosslinking agent exceeds 13 parts by weight, a defect may occur due to a bridge phenomenon between patterns attributable to excessive crosslinking.

The photoacid generator may include at least one selected from the group consisting of: In one preferred embodiment of the present invention, the photoacid generator may be one or more selected from the group consisting of tris(trichloromethyl)triazine, 1,1-bis(p-chlorophenyl)-2,2,2,-trichloroethane, tris(methanesulfonyl)benzene, 1,1-bis(chlorophenyl)-2,2,2,-trichloroethanol, 2,4,6-tris(tribromomethyl)-s-triazine, 2-methyl-4,6-bis(tribromomethyl)-s-triazine, 2-phenyl-4,6-bis(tribromomethyl)-s-triazine, 2-(4-methoxy-phenyl)-4,6-bis(trichloromethyl)-1,3,5-triazine, 2,4,6,-tris(chloromethyl)1,3,5-triazine, triphenylsulfoniumtriflate, and tribromopheylsulfone.

The photoacid generator is preferably included in an amount of 1 to 7 parts by weight based on 100 parts by weight of the polymer resin. When the photoacid generator is used in an amount of less than 1 part by weight, it is impossible to form a pattern due to an insufficient crosslinking density. When the photoacid generator is used in an amount of larger than 7 parts by weight, pattern defects such as light width roughness (LWR) and light edge roughness (LER) may occur in the wall surface or edge of patterns.

The acid diffusion inhibitor may include at least one selected from the group consisting of: methyltriamine, ethyltriamine, dimethylamine, diethylamine, trimethylamine, triethylamine, tributhylamine, methanol triamine, ethanoltriamine, dimethanolamine, diethanolamine, trimethanolamine, triethanolamine and tributanolamine.

The acid diffusion inhibitor is preferably included in an amount of 0.3 to 0.9 parts by weight based on 100 parts by weight of the polymer resin. When the acid diffusion inhibitor is used in an amount of less than 0.3 parts by weight, pattern defects such as LWR and LER may occur on the wall surface or edge of patterns. When the acid diffusion inhibitor is used in an amount of larger than 0.9 parts by weight, it may be impossible to form a pattern.

The I-line negative photoresist composition of the present invention may be applied in a thickness of 1,000Å to 100,000Å depending on the type of the solvent. In the I-line negative photoresist composition, the components may be dissolved in 700 to 1000 parts by weight based on 100 parts by weight of the polymer resin.

The solvent may include at least one selected from the group consisting of ethyleneglycolmonomethylether, ethyleneglycolmonoethylether, methylcellosolveacetate, ethylcellosolveacetate, diethyleneglycolmonomethylether, diethyleneglycolmonoethylether, propyleneglycolmethyletheracetate, propyleneglycolpropyletheracetate, diethyleneglycoldimethylether, ethyllactate, toluene, xylene, methylethylketone, cyclohexanone, 2-heptanone, 3-heptanone, and 4-heptanone.

As described above, since the I-line negative photoresist composition of the present invention includes a compound represented by Formula 1, the photoresist composition is suitable for use in a semiconductor manufacturing process, and the process margin even under an I-line light source (365 nm) is improved because a pattern center-edge height difference is reduced, and a profile with an increased verticality can be implemented.

### Mode For Invention

### [Example]

Hereinafter, the present invention will be described in more detail through examples. These examples are presented only for illustrative purposes, and it will be apparent to those of ordinary skill in the art that the scope of the present invention is not to be construed as being limited by these examples.

### Substitution Reaction Example 1

61.2 g of 1,1,1-tris(4-hydroxyphenyl)-1-ethyl-4-isopropylbenzene, 74.5 g of triethylamine, and 250 ml of anhydrous tetrahydrofuran were added to and stirred in a 500 ml three-necked round flask equipped with an argon reflux device, using a magnetic bar. After 10 minutes of stirring under argon atmosphere, 36.2 g of acryloylchloride was slowly added thereto using a draping panel for 10 minutes, and then stirred at room temperature for 2 years. The resulting reaction mixture was filtered, and then a filter cake (solid) obtained through the filtration was washed two times. The filter cake was completely dissolved in 150 ml of chloroform and purified five times using a 500-ml separatory funnel. Finally, a solution resulting from the dissolution in chloroform was purified by column chromatography using a 1:1 solvent of methylene chloride and hexane to remove unreacted reactants. Finally, a white solid product having the same structure as Formula 1 (R: acryloyl) and having a weight average molecular weight of 586 was obtained, and no unreacted material was identified through gel chromatography analysis.

### Example 1

A negative photoresist composition for I-line was prepared using a mixture of: 100 g of a phenolic polymer resin having 4-hydroxy-3-methyl benzoic acid having an average molecular weight of 5,000 as a basic structure, as a base resin; 5.0 g of the compound presented in the section "Substitution Reaction Example 1"; 10 g of tetramethoxymethyl glycoluril as a crosslinking agent; 4 g of 2-(4-methoxy-phenyl)-4,6-bis(trichloromethyl)-1,3,5-triazine as a photoacid generator; 0.6 g of tributylamine as an acid diffusion inhibitor; 150 g of ethyl lactate as a solvent; and 700 g of propylene glycol methyl ether acetate. The prepared composition was filtered using a 0.1-pm Teflon syringe filter, then applied on a silicon wafer provided with contact hole patterns thereon (hole size: 5.0 um) using a spin coater, then soft-baked at 90°C for 90 seconds, and then exposed to a 365-nm light source. After the exposure process was completed, a baking process was performed at 110°C for 90 seconds, and then a development process using 2.38% tetramethylammonium hydroxide as a developer was performed to form a pattern.

### Example 2

An experiment was carried out in the same manner as in Example 1, except that the compound presented in Substitution Reaction Example 1 was used in an amount of 10.0 g.

### Example 3

An experiment was carried out in the same manner as in Example 1, except that the compound presented in Substitution Reaction Example 1 was used in an amount of 20.0 g.

### Example 4

An experiment was carried out in the same manner as in Example 1, except that the compound presented in Substitution Reaction Example 1 was used in an amount of 30.0 g.

### Example 5

An experiment was carried out in the same manner as in Example 1, except that the compound presented in Substitution Reaction Example 1 was used in an amount of 40.0 g.

### Example 6

An experiment was carried out in the same manner as in Example 1, except that the compound presented in Substitution Reaction Example 1 was used in an amount of 50.0 g.

### Example 7

An experiment was carried out in the same manner as in Example 1, except that the compound presented in Substitution Reaction Example 1 was used in an amount of 60.0 g.

### Example 8

An experiment was carried out in the same manner as in Example 1, except that the compound presented in Substitution Reaction Example 1 was used in an amount of 70.0 g.

### Example 9

An experiment was carried out in the same manner as in Example 1, except that the compound presented in Substitution Reaction Example 1 was used in an amount of 80.0 g.

### Example 10

An experiment was carried out in the same manner as in Example 1, except that the compound presented in Substitution Reaction Example 1 was used in an amount of 90.0 g.

### Example 11

An experiment was carried out in the same manner as in Example 1, except that the compound presented in Substitution Reaction Example 1 was used in an amount of 100.0 g.

### Comparative Example 1

An experiment was carried out in the same manner as in Example 1, except that the compound obtained in Substitution Reaction Example 1 was not added.

### Comparative Example 2

An experiment was carried out in the same manner as in Example 1, except that the compound presented in Substitution Reaction Example 1 was used in an amount of 2.5 g.

### Comparative Example 3

An experiment was carried out in the same manner as in Example 1, except that the compound presented in Substitution Reaction Example 1 was used in an amount of 110.0 g.

### Measurement of mechanical properties

The properties of the I-line negative photoresist compositions prepared according to Examples 1 to 11 and Comparative Examples 1 to 3 were measured.

To identify the profile characteristics, line edge roughness (LER) was observed using a critical dimension-scanning microscope (CD-SEM) capable of observing the critical dimension (CD) of the pattern line width on each of the wafers obtained in Examples 1 to 11 and Comparative Examples 1 to 3, and the height difference (Gap = Center height - Edge height) was measured from the heights of the edge and center of a contact hole (C/H) pattern by using a field emission-scanning electron microscope (FE-SEM) capable of observing a cross profile.

Table 1 shows the results measured in the way described above.

**[Table 1]**

| Classification | | Gap = \|Center - Edge\| | Line and Edge Roughness (LER) |
|---|---|---|---|
| Example | 1 | 79 | 7 |
| | 2 | 70 | 8 |
| | 3 | 66 | 9 |
| | 4 | 64 | 9 |
| | 5 | 61 | 10 |
| | 6 | 60 | 10 |
| | 7 | 58 | 10 |
| | 8 | 57 | 9 |
| | 9 | 56 | 8 |
| | 10 | 55 | 8 |
| | 11 | 55 | 7 |
| Comparative Example | 1 | 100 | 4 |
| | 2 | 88 | 4 |
| | 3 | 55 | 1 |
| | | | |

| | | | |
|---|---|---|---|
| * Gap = Center - Edge: The result of Comparative Example 1 is a relative comparison value based on 100. The lower the better. * Line and Edge Roughness (LER) : 10 (Good), 5 (Average), 1 (Bad) | | | |

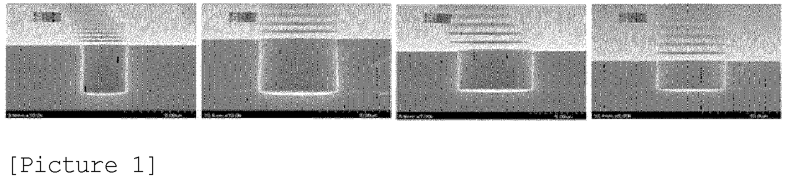

Picture 1 shows pattern wafers used in Examples 1 to 11 and Comparative Examples 1 to 3. The pattern wafers included contact hole patterns with contact hole sizes of 3.0 um, 5.0 um, 7.0 um, and 9.0 um based on a contact hole size. In the examples, the contact hole size was 5.0 um.

As shown in Table 1, Examples 1 to 11 exhibited a considerable improvement in terms of contact-edge height difference like Comparative Example 1 and exhibited as good LER characteristic as a value of 7 or more. Therefore, the test results indicated that the wafers of Examples 1 to 11 were usable.

As can be seen from the results of Comparative Example 1, when the compound represented by Formula 1 was not included, there was no improvement in the center-edge height difference, and the LER characteristic was as low as a value of 4. That is, the wafer of Comparative Example was not usable.

In addition, as can be seen from the results of Comparative Example 2, when the compound represented by Formula 1 was used in an amount of 2.5 g or less, the improvement effect in terms of the center-edge height difference is very low, and the LER characteristic was as low as a value of 4 which indicates the level below the average. Therefore, the wafer was determined to be unusable.

As can be seen from the results of Comparative Example 13, when the compound represented by Formula 1 was included in an amount of larger than 110 g, the effect of reducing the center-edge high difference was good, but the LER characteristic was as bad as a value of 1. That is, the wafer was determined to be unusable.

Consequently, when the compound represented by Formula 1 is included in an amount that falls within the optimal content range set forth in Examples 1 to 11, it is confirmed that the phenomenon in which a middle part of a pattern is depressed (i.e., center-edge height difference) can be weakened, and the LER characteristic is also good. Therefore, when the composition is applied to a process, the composition provides a good process margin. That is, the present invention provides an I-line negative photoresist composition providing an improved process margin.

All simple modifications or alterations of the embodiments may be readily practiced by those skilled in the art, and thus all such modifications or alterations will fall within the scope of the present disclosure.

## Claims

1. An I-line negative photoresist composition for reducing a center-edge height difference and improving a line and edge roughness (LER) characteristic during a pattern forming process for manufacturing a semiconductor device, the composition comprising:
1) a polymer resin;
2) a compound represented by Formula 1 below,
3) a crosslinking agent;
4) a photoacid generator;
5) an acid diffusion inhibitor; and
6) a solvent: 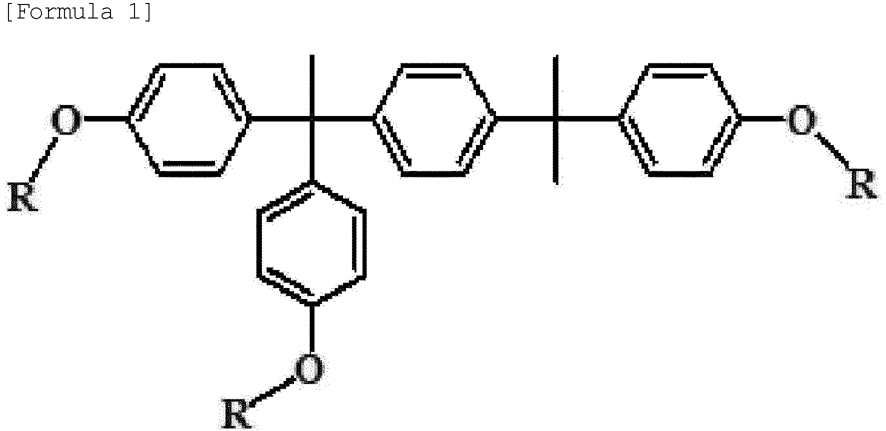 in Formula 1, R's are the same or different from each other and are each independently any one selected from the group consisting of acryloyl, allyl, 3-etoxyacryloyl, dimethylsilaneallyl, methylacryl, trans-3-(benzoyl)acryl, 3-(2furyl)acryl, 4-(benzyloxy)benzyl, and 1,4-bisacryloylpiperazine.

2. The composition of claim 1, comprising 100 parts by weight of the polymer resin, 5 to 100 parts by weight of the compound represented by Formula 1, 7 to 13 parts by weight of the crosslinking agent, 1 to 7 parts by weight of the photoacid generator, 0.3 to 0.9 parts by weight of the acid diffusion inhibitor, and 700 to 1,000 parts by weight of the solvent.

3. The composition of claim 2, wherein the compound represented by Formula 1 is a compound obtained by a monomer substitution reaction of 1,1,1-tris(4-hydroxyphenyl)-1-ethyl-4-isopropylbenzene.

4. The composition of claim 2, wherein the compound represented by Formula 1 has a weight average molecular weight of 550 to 600.

5. The composition of claim 2, wherein the polymer resin comprises at least one selected from the group consisting of: a phenolic polymer resin containing a hydroxyl group and having a weight average molecular weight of 2,000 to 25,000; and a cresol polymer having a weight average molecular weight of 2,000 to 25,000.

6. The composition of claim 5, a monomer of the phenolic polymer resin comprises at least one selected from the group consisting of 4-hydroxy-3-methyl benzoic acid, 4-hydroxy-2-methyl benzoic acid, 5-hydroxy-2-methyl benzoic acid, 3,5-di-tert-butyl-4-hydroxy benzoic acid, 4-hydroxy-3,5-dimethyl benzoic acid, 4-hydroxy isophthalic acid, 2,4,6-hydroxy toluene, 2,4,6-trihydroxy benzoic acid monohydrate, and 2,4,6-trihydroxy benzaldehyde, and
a monomer of the cresol polymer comprises at least one selected from the group consisting of ortho-cresol (o-cresol), para-cresol (p-cresol), meta-cresol (m-cresol), epoxy o-cresol, epoxy p-cresol, and epoxy m-cresol.

7. The composition of claim 2, wherein the crosslinking agent is one or more agents selected from the group consisting of: tris(2,3-epoxypropyl)isocyanurate, trimethylolmethanetriglycidylether, trimethylolpropanetriglycidylether, hexamethylolmelamine, trimethylolethanetriglycidylether, hexamethoxymethylmelamine, hexamethoxyethylmelamine, tetramethylol 2,4-di-amino-1,3,5-triazine, tetramethoxymethyl-2,4-diamino-1,3, 5-triazine, tetramethylolglycoluril, tetramethoxymethylglycoluril, tetramethoxyethylglycoluril, tetramethylolurea, tetramethoxymethylurea, tetramethoxyethylurea, and tetramethoxyethyl-2,4-diamino-1,3,5-troazine.

8. The composition of claim 2, wherein the photoacid generator comprises one or more selected from the group consisting of:
tris(trichloromethyl)triazine, 1,1-bis(p-chlorophenyl)-2,2,2,-trichloroethane, tris(methanesulfonyl)benzene, 1,1-bis(chlorophenyl)-2,2,2,-trichloroethanol, 2,4,6-tris(tribromomethyl)-s-triazine, 2-methyl-4,6-bis(tribromomethyl)-s-triazine, 2-phenyl-4,6-bis(tribromomethyl)-s-triazine, 2-(4-methoxy-phenyl)-4,6-bis(trichloromethyl)-1,3,5-triazine, 2,4,6,-tris(chloromethyl)1,3,5-triazine, triphenylsulfoniumtriflate, and tribromopheylsulfone.

9. The composition of claim 2, wherein the acid diffusion inhibitor comprises one or more selected from the group consisting of: methyltriamine, ethyltriamine, dimethylamine, diethylamine, trimethylamine, triethylamine, tributhylamine, methanol triamine, ethanoltriamine, dimethanolamine, diethanolamine, trimethanolamine, triethanolamine and tributanolamine.
